Europäisches Patentamt

**European Patent Office**

Office européen des brevets

(19)

(11) Veröffentlichungsnummer: **0 210 292**
**B1**

(12) **EUROPÄISCHE PATENTSCHRIFT**

(45) Veröffentlichungstag der Patentschrift:
26.09.90

(21) Anmeldenummer: 85109489.6

(22) Anmeldetag: 27.07.85

(51) Int. Cl.⁵: **H03D 3/00**

(54) Frequenzdemodulationsschaltung mit Nulldurchgangszählung.

(43) Veröffentlichungstag der Anmeldung:
04.02.87 Patentblatt 87/6

(45) Bekanntmachung des Hinweises auf die Patenterteilung:
26.09.90 Patentblatt 90/39

(84) Benannte Vertragsstaaten:
DE FR GB IT NL

(56) Entgegenhaltungen:
EP-A- 0 099 142
EP-A- 0 146 652
US-A- 4 378 526

PATENTS ABSTRACTS OF JAPAN, Band 6, Nr. 21 (E-93)
[899], 6. Februar 1982; & JP - A - 56 140 706 (NIPPON
DENSHIN DENWA KOSHA) 04-11-1981
IBM TECHNICAL DISCLOSURE BULLETIN, Band 13,
Nr. 11, April 1971, Seiten 3421-3422, New York, US; G.D.
JONES, Jr.: "Digital frequency discriminator"
RCA TECHNICAL NOTES, Nr. 839, 4. Juni 1969,
Seiten 1/2-2/2, RCA, Princeton, New York, US; D.P.
WEBSTER et al.: "Correlation data demodulator"

(73) Patentinhaber: **Deutsche ITT Industries GmbH,
Hans-Bunte-Strasse 19 Postfach 840,
D-7800 Freiburg(DE)**

(72) Erfinder: **Pfeifer, Heinrich, Dipl.-Ing., Vogesenstrasse 4,
D-7809 Denzlingen(DE)**
Erfinder: **Schweer, Rainer, Dr. Ing., Lärchenweg 14,
D-7808 Waldkirch(DE)**

**Beschreibung**

Die Erfindung betrifft eine digitale Frequenzdemodulationsschaltung nach dem Prinzip der Ermittlung der innerhalb einer bestimmten Zeitdauer auftretenden Anzahl von Nulldurchgängen eines zu demodulierenden bandbegrenzten Signals mittels eines periodisch zurückgesetzten Zählers, wobei der Zählschaltung als Steuersingale das Ausgangs- und das Eingangssignal eines Verzögerers zugeführt sind, dessen Eingang mit dem digitalisierten FM-Signal gespeist ist, vgl. den Oberbegriff des Patentanspruchs. Dieses Prinzip ist in "Patent Abstracts of Japan", Band 6, Nr. 21 (E-93) (899), 6.Februar 1982 (sowie JP-A 56/140 706) als derjenige Stand der Technik beschrieben, gegenüber dem der in dieser Patentschrift geschützte Gegenstand abgegrenzt ist.

In US-A 4 378 526 ist ein digitaler Demodulator für PCM-Signale beschrieben, die FSK- (= frequency shift keyed) codiert sind. Diese Schaltung enthält ebenfalls eine Einrichtung zur Erkennung von Signal-Nulldurchgängen und eine Einrichtung zur Erkennung von Vorzeichenwechseln. Hierzu dient ein Register als Verzögerungseinrichtung, dessen Ein- und Ausgangssignal der Vorzeichenwechsel-Auswerteschaltung zugeführt sind. Die Demodulationsschaltung enthält ferner einen Festwertspeicher (= ROM), der insbesondere der sinusförmigen Interpolation dient. Schließlich weist die beschriebene Demodulationsschaltung auch einen Addierer und einen Akkumulator auf, die über einen Multiplexer entweder an den Festwertspeicher oder an einen digitalen Zählgenerator gekoppelt sind.

Der im Patentanspruch angegebenen Erfindung liegt die Aufgabe zugrunde, die in der genannten Patentschrift geschilderten Nachteile des bekannten Prinzips weitgehend zu beheben, die im wesentlichen in einer Genauigkeitsverminderung bei zu großem Frequenzhub besteht. Dabei soll das aus dieser Patentschrift an sich bekannte Digital-Prinzip zur Frequenzdemodulation auf das Prinzip der Ermittlung der innerhalb einer bestimmten Zeitdauer auftretenden Anzahl von Nulldurchgängen angewendet werden.

Dabei ergibt sich unter anderem der Vorteil, daß als digitale Rechenschaltungen lediglich Addierer erforderlich sind, während bei den verschiedenen Ausführungsbeispielen des genannten Standes der Technik unter anderem Multiplizierer und Dividierer erforderlich sind. Gerade aber diese digitalen Rechenschaltungen erfordern einen erheblichen Aufwand an Halbleiterkristallfläche von integrierten Schaltungen, mit denen derartige Frequenzdemodulationsschaltungen üblicherweise realisiert werden. Die erfindungsgemäße Lösung hat daher auch den Vorteil, daß sie mit wesentlich weniger Halbleiterkristallfläche als die bekannte Anordnung auskommt. Sie ist insbesondere vorteilhaft anwendbar, wenn relativ schamlbandige Signale auf eine hohe Trägerfrequenz moduliert sind, wie dies z.B. für die Audiosignale der üblichen Fernseh-Standards (PAL, NTSC, SECAM) zutrifft.

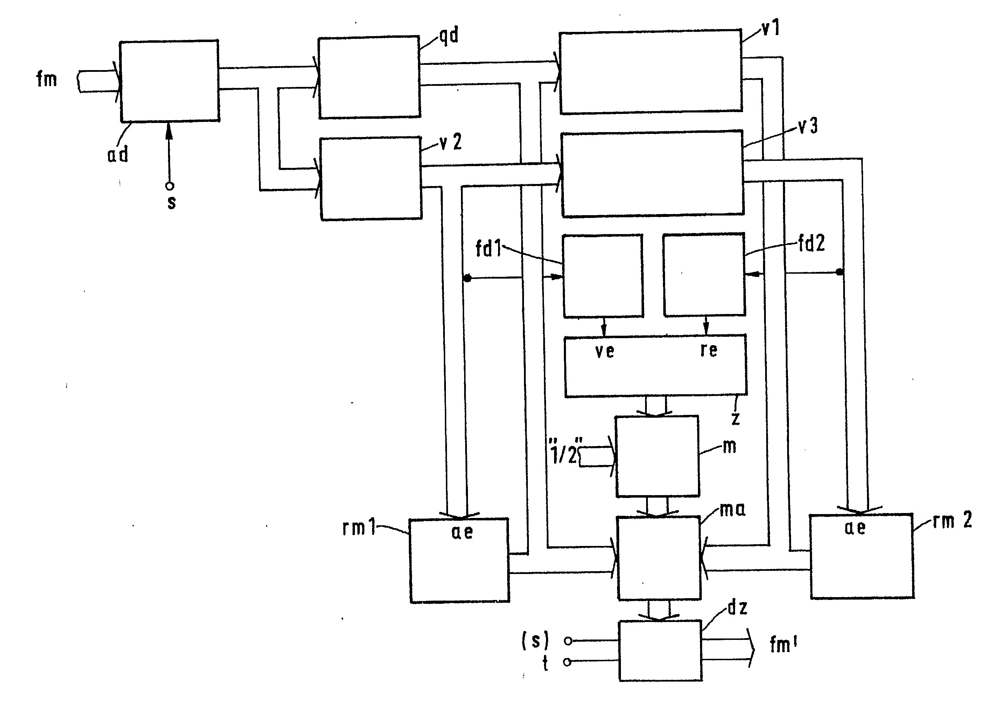

Die Erfindung wird anhand der Figur der Zeichnung, die ein schematisiertes Schaltbild eines Ausführungsbeispiels darstellt, näher erläutert. Das zu demodulierende bandbegrenzte Signal ist als amplitudennormiertes Signal fm dem Eingang des Analog-Digital-Wandlers ad zugeführt, der vom Abtastsignal s getaktet ist. Seine Frequenz ist entsprechend dem Abtasttheorem mindestens doppelt so hoch zu wählen wie die Summe aus der Trägerfrequenz und der Hälfte der sogenannten Carson-Bandbreite. Die erwähnte Amplitudennormierung kann sowohl vor oder hinter dem Analog-Digital-Wandler ad erfolgen, d.h. entweder auf der analogen oder der digitalen Signalseite, und beispielsweise durch eine analoge bzw. digitale Amplitudenregelschaltung vorgenommen werden.

Der Ausgang des Analog-Digital-Wandlers ad liegt am Eingang des Quadrantendetektors qd, mittels dem festgestellt wird, in welcher Viertelperiode der Periodendauer des Signals fm dessen gerade vorliegender Abtastwert liegt. Dabei ist die in der Mathematik bei der Diskussion der trigonometrischen funktionen übliche Quadrantenaufteilung gemeint; der erste Quadrant entspricht also dem Winkelbereich von 0 bis 90°, der zweite dem von 90° bis 180°, der dritte dem von 180° bis 270° und der vierte dem von 270° bis 360° bzw. 0°. Da somit ein Digitalsignal für vier mögliche Zustände mittels des Quadrantendetektors qd erzeugt wird, ist dies im natürlichen Binärcode eine zweistelliges Digitalsignal. Aus der Anwendung des Quadrantendetektors qd ergibt sich auch die zusätzliche Bedingung bezüglich der Frequenz des Abtastsignals s, daß sie nämlich größer als das Vierfache der oben erwähnten Summe aus Trägerfrequenz und halber Carson-Brandbreite sein muß.

Das Ausgangssignal des Quadrantendetektors qd ist dem ersten Verzögerer v1 zugeführt, dessen Verzögerungszeit gleich dem k-fachen der Periodendauer des Abtastsignals s ist. Dabei ist mit k das ganzzahlige Verhältnis von Frequenz des Abtastsignals s zu Frequenz desjenigen Taktsignals t bezeichnet, in dessen Takt die Digitalworte des demodulierten Signals fm' weiterverarbeitet werden. Die Frequenz dieses Taktsignals t ist dabei in Übereinstimmung mit dem Abtasttheorem mindestens doppelt so groß wie die höchste im demodulierten Signal fm' auftretende Frequenz zu wählen.

Der Ausgang des Analog-Digital-Wandlers ad ist ferner mit dem Eingang des zweiten Verzögerers v2 verbunden, dessen Verzögerungszeit gleich der des Quadrantendetektors qd ist und dessen Ausgang am Eingang des dritten Verzögerers v3 liegt, dessen Verzögerungszeit gleich der des ersten Verzögerers v1 ist.

Der Ausgang des zweiten bzw. der des dritten Verzögerers v2, v3 liegt am jeweiligen Andreßeingang ae des ersten bzw. zweiten Arcus-Sinus-Festwertspeichers rm1, rm2, in welchen beiden die Arcus-Sinuswerte des ersten Quadranten der Sinusfunktion fest gespeichert sind, und zwar derart, daß einem entsprechenden Adreßsignal das zugehörige Argument- bzw. Winkelsignal am Ausgang des Festwertspeichers zugeordnet ist.

Das jeweilige Ausgangssignal der beiden Festwertspeicher rm1, rm2 ist mit dem Ausgangssignal des Quadrantendetektors qd bzw. dem des ersten Verzögerers v1 vereinigt, d.h. den Stellen des Ausgangssignals des jeweiligen Festwertspeichers sind als weitere Stellen die beiden Stellen des Ausgangssignals des Quadrantendetektors qd bzw. des ersten Verzögerers v1 hinzugefügt. Diese Signals sind dann dem Mehrfachaddierer ma zugeführt.

Die jeweilige Vorzeichenstelle des Ausgangs des zweiten bzw. dritten Verzögerers v2, v3 liegt über den jeweiligen Flankendetektors fd1, fd2 am Vorwärtszähl- bzw. Rückwärtszähleingang ve, re des Vorwärts-Rückwärts-Zählers z, dessen Zählerstandausgang über den 1/2-Multiplizierer m einem weiteren Eingang des Mehrfachaddierers ma zugeführt ist.

Dem Ausgang des Mehrfachaddierers ma ist der Dezimierer dz nachgeschaltet, der vom Taktsignal t und gegebenenfalls auch vom Abtastsignal s getaktet ist. An seinem Ausgang ist das digitale demodulierte Signal fm' abzugreifen. Mittels des Dezimierers dz wird die Datenfolge von der Abtastsignalfrequenz auf die Taktsignalfrequenz reduziert.

Die beiden Flankendetektoren fd1, fd2 sprechen auf einen signalwechsel der erwähnten Vorzeichenstelle, nämlich auf die Flanke eines H-L- bzw. L-H-Wechsels an, wobei mit H bzw. L die beiden Pegel eines Binärsignal bezeichnet sind.

Die Frequenzdemodulationsschaltung nach der Erfindung unterscheidet sich von dem eingangs erwähnten analogen Frequenzdemodulator nicht nur dadurch, daß sie als Digitalschaltung realisiert ist, sondern aus dieser Tatsache ergeben sich auch spezifische Einzelheiten, die bei der analogen Schaltung kein Äquivalent haben. So ist z.B. durch die Wahl des Vorwärts-Rückwärts-Zählers z als Äquivalent des bei dem bekannten Prinzip vorhandenen Zählers die dortige periodische Rückstellung entbehrlich geworden. Während beim bekannten Prinzip die Zeit zwischen zwei Rückstellimpulsen die Meßzeit darstellt, ist bei der Erfindung die von der Größe k bestimmte Verzögerungszeit des ersten und dritten Verzögerers v1, v3 der Meßzeit äquivalent.

Bei der Erfindung sind der Quadrantendetektor qd und die drei Verzögerer v1, v2, v3 getaktete Schaltungen, denen das Taktsignal s zugeführt ist, was in der Figur jedoch aus Übersichtlichkeitsgründen nicht gezeigt ist. Auch der Dezimierer dz ist eine getaktete Schaltung.

Wie bereits eingangs erwähnt wurde, läßt sich die erfindungsgemäße Frequenzdemodulationsschaltung als integrierte Schaltung realisieren, wobei insbesondere integrierte Isolierschicht-Feldeffekttransistor-Schaltungen (MOS-Schaltungen) von Vorteil sind, da es sich um eine reine Digitalschaltung handelt.

## Patentansprüche

Digitale Frequenzdemodulationsschaltung nach dem Prinzip der Ermittlung der innerhalb einer bestimmten Zeitdauer auftretenden Anzahl von Nulldurchgängen eines zu demodulierenden, bandbegrenzten Signals (fm) mittels eines periodisch zurückgesetzten Zählers, mit einem Verzögerer, dessen Ausgangssignal zusammen mit dem Eingangssignal der Zählschaltung zugeführt ist, dadurch gekennzeichnet, daß die digitale Frequenzdemodulationsschaltung folgende Merkmale aufweist:

– das Signal (fm) ist amplitudennormiert einem von einem Abtastsignal (s) getakteten Analog-Digital-Wandler (ad) zugeführt, dessen Ausgang am Eingang eines Quadrantendetektors (qd) liegt, dessen Ausgang mit dem Eingang eines ersten Verzögerers (v1) verbunden ist, dessen Verzögerungszeit gleich dem k-fachen der Periodendauer des Abtastsignals (s) ist, wobei k gleich dem ganzzahligen Verhältnis von Frequenz des Abtastsignals (s) zu Frequenz desjenigen Taktsignals (t) ist, in dessen Takt die Digitalworte des demodulierten Signals (fm') weiterverarbeitet werden,

– der Ausgang des Analog-Digital-Wandlers (ad) liegt am Eingang eines zweiten Verzögerers (v2), dessen Verzögerungszeit gleich der des Quadrantendetektors (qd) ist,

– der Ausgang des zweiten Verzögerers (v2) liegt am Eingang eines dritten Verzögerers (v3) mit derselben Verzögerungszeit, wie sie der erste Verzögerer (v1) aufweist,

– die jeweilige Vorzeichenstelle des Ausgangs des zweiten bzw. des dritten Verzögerers (v2, v3) liegt über jeweils einen Flankendetektor (fd1, fd2) am Vorwärtszähl- bzw. Rückwärtszahleingang (ve, re) eines Vorwärts-Rückwärts-Zählers (z),

– der Ausgang des zweiten bzw. der des dritten Verzögerers (v2, v3) liegt am jeweiligen Adreßeingang (ae) eines ersten bzw. zweiten Arcus-Sinus-Festwertspeichers (rm1, rm2), deren jeweiliges Ausgangssignal mit dem Ausgangssignal des Quadrantendetektors (qd) bzw. dem des ersten Verzögerers (v1) vereinigt ist und zusammen mit dem über einen 1/2-Multiplizierer (m) geführten Zählerstandsignal des Vorwärts-Rückwärts-Zählers (z) einen Mehrfachaddierer (ma) speist,

– der Ausgang des Mehrfachaddierers (ma) liegt am Eingang eines vom Abtastsignal (s) und gegebenenfalls vom Taktsignal (t) getakteten Dezimierers (dz), an dessen Ausgang das digitale demodulierte Signal (fm') abzugreifen ist.

## Claims

Digital frequency demodulator circuit working on the principle of determining the number of zero crossings of a bend-limited input signal (fm) in a given period of time by means of a periodically reset counter and comprising a delay element whose output signal, characterized in that the digital frequency demodulator circuit has the following features:

– The signal (fm), after being amplitude-normalized, is applied to an analog-to-digital converter (ad) clocked by a sampling signal (s) and having its output connected to the input of a quadrant detector (qd) whose output is coupled to the input of a first delay equal to k times the period of the sampling signal (s), where k is equal to the integral ratio of the frequency of the integral ratio of the frequency of the sampling signal (s) to the frequency of the clock signal (t) at the pulse repetition rate of which the digital words of the demodulated signal (fm') are processed;
- the output of the analog-to-digital converter (ad) is coupled to the input of a second delay element (v2) providing a delay equal to that of the quadrant detector (qd);
- the output of the second delay element (v2) is coupled to the input of a third delay element (v3) providing the same delay as the first delay element (v1);
- the sign bits of the outputs of the second delay element (v2) and the third delay element (v3) are fed, respectively, to the up input (ve) and the down input (re) of an up/down counter (z) via two edge detectors (fd1, fd2);
- the outputs of the second delay element (v2) and the third delay element (v3) are coupled to the address inputs (ae) of a first arcsin read-only memory (rm1) and a second arcsin read-only memory (rm2), respectively, whose output signals are combined with the output signals of the quadrant detector (qd) and the first delay element (v1), respectively, and are fed, together with the count signal of the up/down counter (z), to a multiple adder (ma), the count signal being applied to the multiple adder (ma) through a 1/2 multiplier (m), and
- the output of the multiple adder (ma) is coupled to the input of a decimator (dz) which is clocked by the sampling signal (s) and, if necessary, by the clock signal (t) and provides the digital demodulated signal (fm').

**Revendications**

Circuit numérique de démodulation de fréquence fonctionnant selon le principe de la détermination du nombre, apparaissant pendant une durée déterminée, d'annu- lations d'un signal f(m) qui doit être démodulé et possède une bande limitée, à l'aide d'un compteur ramené à zéro périodiquement, et comportant un dispositif de retardement, dont le signal de sortie est envoyé conjointement avec le signal d'entrée au circuit de comptage, caractérisé en ce que le circuit numérique de démodulation de fréquence possède les caractéristiques suivantes:
- le signal f(m) est envoyé, avec une amplitude normalisée, à un convertisseur analogique/numérique (ad), qui est commandé de façon cadencée par un signal d'échantillonnage (s) et dont la sortie est raccordée à l'entrée d'un détecteur à quadrants (qd), dont la sortie est reliée à l'entrée d'un premier dispositif de retardement (v1), qui produit un retard égal à k fois la durée de la période du signal d'échantillonnage (s), k étant égal au rapport, égal à un nombre entier, de la fréquence du signal d'échantillonnage (s) à la fréquence du signal de cadence (t), à la cadence duquel les mots numériques du signal démodulé (fm') sont traités ultérieurement,
- la sortie du convertisseur analogique/numérique (ad) est raccordée à l'entrée d'un second dispositif de retardement (v2), qui produit un retard égal à celui produit par le détecteur à quadrants (qd),
- la sortie du second dispositif de retardement (v2) est raccordée à l'entrée d'un troisième dispositif de retardement (v3) produisant le même retard que celui produit par le premier dispositif de retardement (v1),
- le signe respectif du signal de sortie des second et troisième dispositifs de retardement (v2, v3) est appliqué, par l'intermédiaire de détecteurs respectifs de flancs (fd1, fd2), aux entrées respectives de comptage progressif et de comptage régressif (ve, re) d'un compteur progressif/régressif (z),
- la sortie des second et troisième dispositifs de retardement (v2, v3) est raccordée à l'entrée respective d'adresses (ae) de première et seconde mémoires mortes (rm1, rm2) de mémorisation de valeurs arcsinus, dont le signal de sortie respectif est réuni au signal de sortie du détecteur à quadrants (qd) ou au signal de sortie du premier dispositif de retardement (v1) et est envoyé, ainsi que le signal d'état de comptage du compteur progressif/régressif (z), envoyé par l'intermédiaire d'un multiplicateur par 1/2 (m), à un additionneur multiple (ma), et
- la sortie de l'additionneur multiple (ma) est raccordée à l'entrée d'un diviseur par dix (dz), qui est commandé de façon cadencée par le signal d'échantillonnage (s) et éventuellement par le signal de cadence (t) et à la sortie duquel peut être prélevé le signal démodulé numérique (fm').